# EUROPÄISCHE PATENTSCHRIFT

(11) **EP 2 143 148 B1**
(45) Veröffentlichungstag und Bekanntmachung des Hinweises auf die Patenterteilung: **29.06.2011**
(21) Anmeldenummer: 08733262.3
(22) Anmeldetag: 08.05.2008
(51) Int. Cl.: H01L 31/048, B32B 27/34

(54) **VERWENDUNG EINES KUNSTSTOFFVERBUNDES FÜR DIE HERSTELLUNG PHOTOVOLTAISCHER MODULE**
USE OF A POLYMER COMPOSITE FOR THE PRODUCTION OF PHOTOVOLTAIC MODULES
UTILISATION D'UN COMPOSITE EN MATIÈRE SYNTHÉTIQUE POUR LA FABRICATION DE MODULES PHOTOVOLTAÏQUES

(30) Priorität: 10.05.2007 AT 7342007
(43) Veröffentlichungstag der Anmeldung: 13.01.2010
(73) Patentinhaber: ISOVOLTAIC AG, 8403 Lebring (AT)
(72) Erfinder: MUCKENHUBER, Harald, A-8053 Graz (AT)
(74) Vertreter: Dungler, Karin
(86) Internationale Anmeldenummer: PCT/AT2008/000159
(87) Internationale Veröffentlichungsnummer: WO 2008/138022

(56) Entgegenhaltungen:
- WO-A-01/67523
- US-A1- 2002 128 412

## Beschreibung

Die Erfindung betrifft die Verwendung eines Kunststoffverbundes für die Herstellung photovoltaischer Module.

Photovoltaische Module dienen zur elektrischen Energieerzeugung aus Sonnenlicht und bestehen aus einem Laminat, welches als Kernschicht ein Solarzellensystem enthält. Diese Kernschicht ist mit Einkapselungsmaterialien umhüllt, die als Schutz gegen mechanische und witterungsbedingte Einflüsse dienen. Diese Materialien können aus einer oder mehreren Schicht(en) aus Glas und/oder Kunststoffolien und/oder Kunststoffverbunden bestehen.

Für witterungsbeständige Folienlaminate werden zur Zeit standardmäßig Folienverbunde aus Fluorpolymerfolien und Polyester verwendet. Die Fluorpolymerfolie an der Außenseite garantiert dabei die Witterungsbeständigkeit, die Polyesterfolie die mechanische Stabilität und die gewünschten elektrischen Isolationseigenschaften. Eine weitere Fluorpolymerfolie an der Innenseite dient zur Anbindung an die Siegelschicht des Solarzellensystems.

Die Fluorpolymerfolien weisen dabei nur eine geringe Haftung zur Siegelschicht, welche als Einbettungsmaterial für die Solarzellen selbst verwendet wird, auf. Des Weiteren trägt die Fluorpolymerfolie nur in untergeordnetem Maß zur elektrischen Isolierung bei, woraus die Notwendigkeit der Verwendung einer vergleichsweise dicken Polyesterfolie resultiert.

Hier will die vorliegende Erfindung Abhilfe schaffen.

Die Erfindung betrifft die Verwendung eines Kunststoffverbundes, umfassend ein Trägermaterial, ausgewählt aus der Gruppe Polyethylenterephthalat (PET), Polyethylennaphthalat (PEN) oder Ethylentetrafluorethylencopolymer (ETFE), sowie beidseitig an das Trägermaterial angrenzende Polyamid 12-Schichten zur Herstellung von photovoltaischen Modulen. Diese Verwendung ermöglicht eine ausgezeichnete Haftung zur Siegelschicht, welche als Einbettungsmaterial für die Solarzelle (n) dient, und erlaubt gleichzeitig die Verwendung dünnerer Polymerfolien, da Polyamid 12 zu Polyester vergleichbare Isolationseigenschaften besitzt.

Vorteilhafte Ausführungsformen der erfindungsgemäßen Verwendung sind in den Patentansprüchen offenbart.

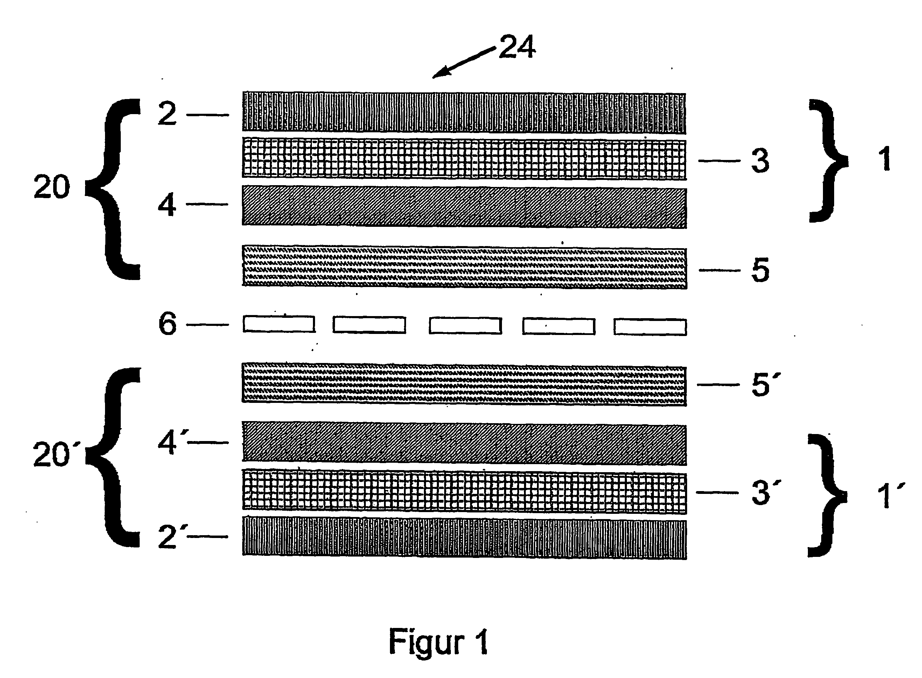

Die Erfindung wird im folgenden anhand möglicher Ausführungsformen der Erfindung - siehe Figuren 1 bis 4 - sowie anhand eines möglichen Ausführungsbeispieles näher erläutert.

Fig. 1 zeigt den beispielhaften Aufbau eines photovoltaischen Moduls 24, in welchem das Solarzellensystem mit dem erfindungsgemäß verwendeten Material 1, 1' eingekapselt ist. Das Einkapselungsmaterial 1, 1' besteht im wesentlichen aus einer witterungsbeständigen Folie 2, 2' und einem Trägermaterial 3, 3', an welches eine Folie 4,4' als Haftvermittler zur Siegelschicht 5, 5' angrenzt. Die Siegelschicht 5, 5' stellt die kraftschlüssige Verbindung zum Solarzellensystem 6 her.

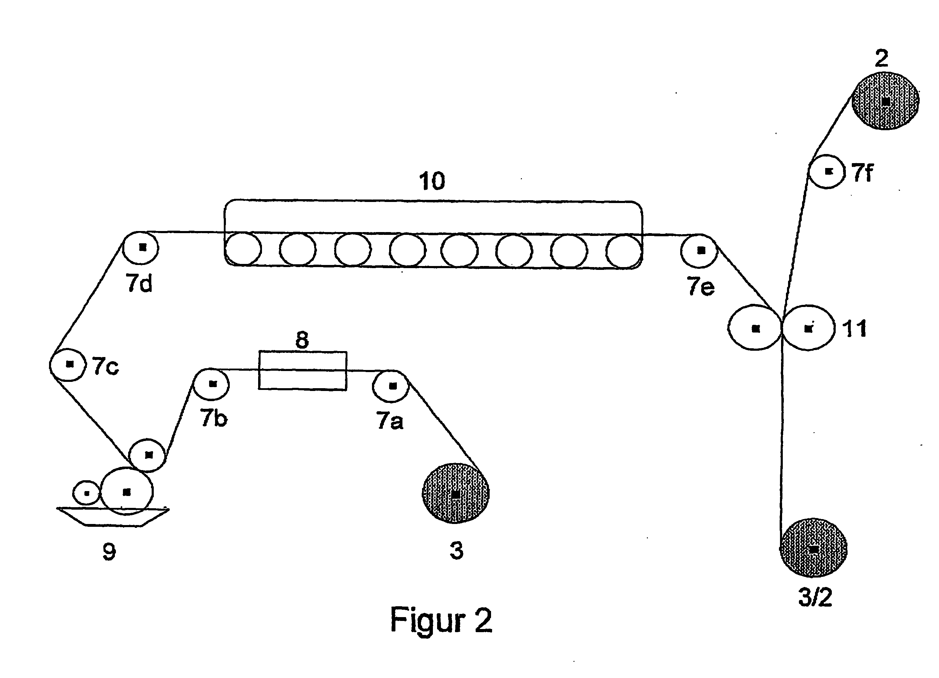

Fig. 2 zeigt eine mögliche Laminiereinrizhtung zur Herstellung des erfindungsgemäß verwendeten Kunststoff Verbundes. Ein Trägermaterial 3, welches gemäß Ausführungsbeispiel ausgewählt wird, wird mittels des Auftragwerkes 9 mit Klebstoff beschichtet und nach dem Durchlaufen eines Trockners 10 mit der witterungsbeständigen Folie 2 verklebt. Die witterungsbeständige Folie 2 kann dabei transparent oder eingefärbt sein. Der Kontakt zwischen den beiden Folien wird durch den Pressdruck zwischen den Walzen 11 gesteuert. Das Trägermaterial 3, welches transparent oder eingefärbt sein kann, kann bei jeder Ausführungsart gemäß Beispiel a) auch mittels physikalischer Medien 8 vorbehandelt werden. In einem zweiten, analogen Verfahrenschritt wird der Verbund 3/2 bestehend aus dem Trägermaterial 3 und der witterungsbeständigen Folie 2 mit der als Haftvermittler dienenden Folie 4 - siehe Fig. 1 - verklebt.

Die als Haftvermittler dienende Folie 4 kann dabei transparent oder eingefärbt sein. Die Verklebung der Trägerfolie 3 kann auch zuerst mit der als Haftvermittler dienenden Folie 4 erfolgen und erst im zweiten Verfahrensschritt mit der witterungsbeständigen Folie 2.

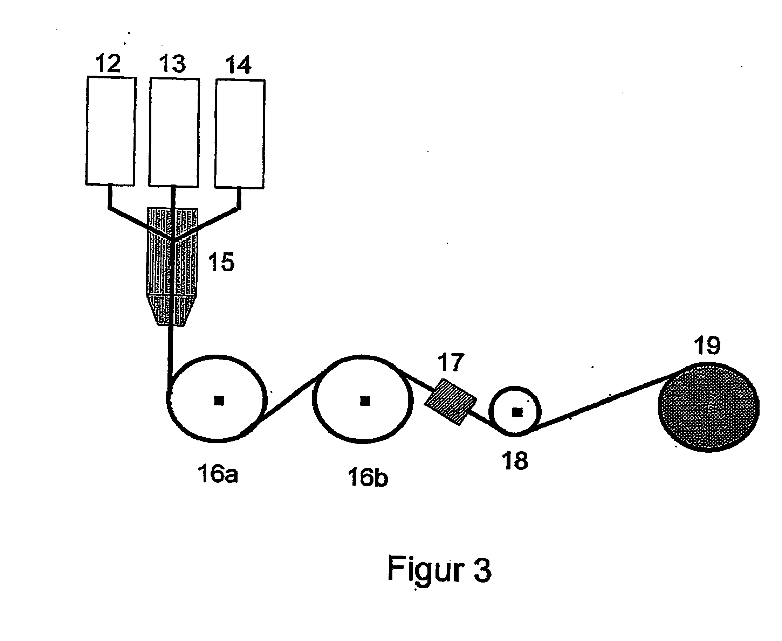

Fig. 3 zeigt schematisch eine mögliche Einrichtung zur Coextrusion der witterungsbeständigen Folie 2, des Trägermaterials 3 und der als Haftvermittler dienenden Folie 4, um einen kraftschlüssigen Verbund zu erzeugen. Die Coextrusions-Anlage kann verfahrensbedingt in ihrem Aufbau abgeändert werden. Schmelzen der Polymere, aus denen die Materialien 2, 3 und 4 bestehen, befinden sich in den Behältern 12, 13 und 14. In jedem der Behälter befindet sich jeweils nur ein Polymer. Über eine Schlitzdüse 15 erfolgt die Herstellung eines Coextrudates der witterungsbeständigen Folie 2, der Trägerfolie 3 und der als Haftvermittler dienenden Folie 4. Dieses Coextrudat wird auf eine Kühlwalze 16a extrudiert und von dort über eine weitere Kühlwalze 16b zur Aufrollung 19 geleitet. Im Verfahrenslauf erfolgt eine Inline-Dickenmessung 17. Zwischen dem Trägermaterial 3 und der witterungsbeständigen Folie 2, bzw. zwischen dem Trägermaterial 3 und der als Haftvermittler dienenden Folie 4, oder auch zwischen dem Trägermaterial 3 und den Folien 2 und 4 kann eine zusätzliche Haftvermittlerschicht, wie z.B. in den Patenten DE 19720317, EP 837088 oder EP 509211 beschrieben, coextrudiert werden. Das Coextrudat besteht in den ersten beiden Fällen aus vier Lagen, im letzten Fall aus fünf Lagen. Die Anlage zur Coextrusion gemäß Fig. 3 kann dafür entsprechend umgebaut werden.

Für die Verwendung des Kunststoffverbundes als Einkapselungsmaterial für Solarzellen 6 wird, wie in Fig. 1 gezeigt, nunmehr der als Rollenware vorliegende Verbund 1 diskontinuierlich abgelängt und in üblichen Laminierverfahren mit der Siegelschicht 5, welche gemäß Ausführungsbeispiel ausgewählt werden kann, verbunden.

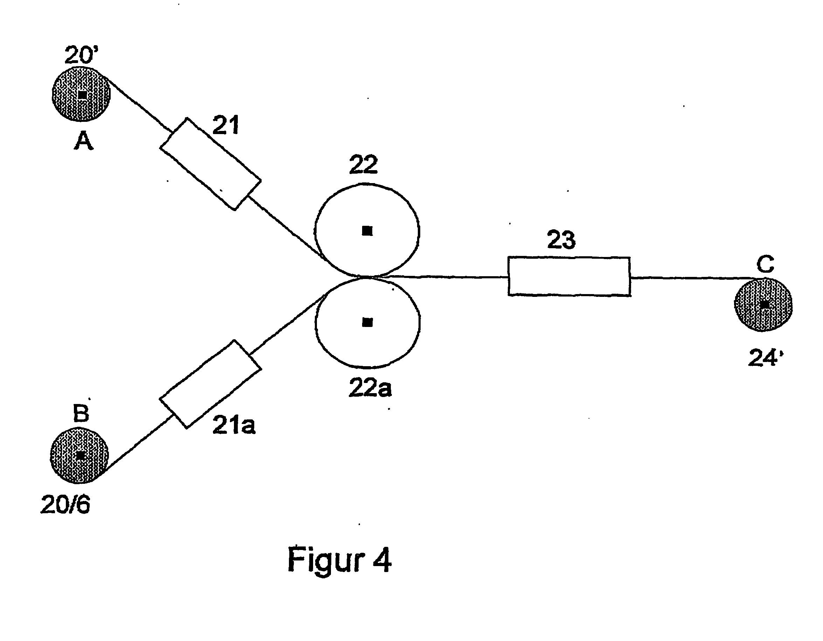

Durch das Laminierverfahren ist zwar ein Verbund der Schichten 2, 3, 4, 5 gegeben, jedoch erfolgt die weitere Aushärtung der im Verbund eingesetzten Kunststoffe bei der Endfertigung des Vorverbundes für ein photovoltaisches Modul 24, welche, wie in Fig. 4 gezeigt, beispielsweise durch ein sogenanntes Rolle zu Rolle Verfahren erfolgen kann.

Dabei wird beispielsweise auf der Aufbewahrungsrolle B ein Verbund 20 bestehend aus dem Einkapselungsmaterial 1 und der Siegelschicht 5 in Verbindung mit dem Solarzellensystem 6, bestehend aus flexiblen Solarzelltypen, aufgerollt. Von der gegenüberliegenden Aufbewahrungsrolle A wird ein weiterer Verbund 20' bestehend aus dem Einkapselungsmaterial 1' und der Siegelschicht 5' abgezogen und dem Solarzellensystem 6, welches gemeinsam mit dem Verbund 20 von der Aufbewahrungsrolle B abgezogen wird, zugeführt. Dabei werden die von den Aufbewahrungsrollen A bzw. B abgezogenen Materialbahnen jeweils einer Heizstation 21 bzw. 21a zugeführt, in welcher die Einkapselungsmaterialien zumindest auf die Erweichungstemperatur der Siegelschicht 5 bzw. 5' erwärmt werden. Dadurch ist die Ausbildung eines Verbundes zwischen den Schichten 20 und 20' einerseits sowie dem Solarzellensystem 6 und den Schichten 20 und 20' andererseits gewährleistet. Um das Aushärten dieses Vorverbundes und das gänzliche Vernetzen der in den Einkapselungsmaterialien eingesetzten Polymere zu erzielen, wird dieser einer Heizstation 23 zugeführt. Der Vorverbund 24' für ein photovoltaisches Modul kann auf der Aufbewahrungsrolle C gelagert und von dieser bei Bedarf entsprechend wieder abgezogen werden.

Das folgende Ausführungsbeispiel gibt mögliche Varianten für die Auswahl der Komponenten in den jeweiligen Schichten wieder: Witterungsbeständige Folie 2,2': Polyamid 12 (PA12), Trägermaterial 3, 3': Polyethylenterephthalat (PET), Polyethylen-naphthalat (PEN), Ethylentetrafluorethylencopolymer (ETFE), sowie Coextrudate daraus in Form von Folien oder Folienverbunden. Folie als Haftvermittler 4, 4': Polyamid 12 (PA12) Siegelschicht 5, 5': Ethylenvinylacetat (EVA), Polyvinylbutyral (PVB), lonomere, Polymethylmethacrylat (PMMA), Polyurethan, Polyester oder Hotmelt.

Die vorgenannten Verbunde können auch einer chemischen oder physikalischen Oberflächenbehandlung unterzogen werden.

Durch die erfindungsgemäße Verwendung von Polyamid 12 als Folie 4, 4', die als Haftvermittler dient, bzw. zusätzlich auch als witterungsbeständige Folie 2, 2', können in einem photovoltaischen Modul 24, wie in Fig. 1 gezeigt, für das Einkapselungsmaterial 1, 1' retativ dünne Trägerfolien 3, 3' verwendet werden. Die Verwendung dünner Trägerfolien 3, 3' ist möglich, da Polyamid 12 im Gegensatz zu Fluorpolymerfolien eine vergleichsweise hohe elektrische Isolat tionsfähigkeit hat. Eine 40 pm dicke PA12-Folie hat eine höchst zulässige Systemspannung von 424V (gemessen nach IEC 60664-1 / IEC 61730-2). Eine PVF-Folie (37 µm) hat eine höchst zulässige Systemspannung von 346V (gemessen nach IEC 60664-1 / IEC 61730-2). Die Isolationsfähigkeit von PA12 ist mit jener von Polyethylenterephthalat vergleichbar.

Die Verwendung von Polyamid 12 als Folie 4, 4', die als Haftvermittler dient, gewährleistet ebenfalls eine deutlich verbesserte Haftung zur Siegelschicht 5, 5' welche gemäß Ausführungsbeispiel ausgewählt werden kann. PA12 weist z.B. zur EVA-Folie (Type Etimex 48.6 Fast Cure) eine Haftung von >60N/cm auf. Mit einer PVF-Folie kann nur eine Haftung von ≥4N/cm garantiert werden. Um zu Polyamid 12 vergleichbare Haftungen zu erzielen, ist bei Fluorpolymerfolien, wie sie zur Zeit standardmäßig in der Einkapselungstechnik für Photovoltaikmodule verwendet werden, eine zusätzlich physikalische Oberflächenbehandlung bzw. chemische Beschichtung (Primer) notwendig.

Die Verwendung von Polyamid 12 hat auch den Vorteil, dass bei Entsorgung der photovoltaischen Module der Anteil an fluorhältigen Polymeren im Vergleich zu handelsüblichen Modulaufbauten vermieden werden kann.

## Patentansprüche

1. Verwendung eines Kunststoffverbundes (1, 1'), umfassend ein Trägermaterial (3, 3'), ausgewählt aus der Gruppe Polyethylenterephthalat (PET), Polyethylennaphthalat (PEN) oder Ethylentetrafluorethylencopolymer (ETFB), sowie beidseitig an das Trägermaterial angrenzende Polyamid 12-Schichten (2, 2', 4, 4') zur Herstellung von photovoltaischen Modulen (24).

2. Verwendung eines Kunststoffverbundes nach Anspruch 1, **dadurch gekennzeichnet, dass** das Trägermaterial (3, 3') mit den Polyamid 12-Schichten (2, 2', 4, 4') über eine Klebstoffschicht kraftschlüssig verbunden ist.

3. Verwendung eines Runststoffverbundes nach Anspruch 2, **dadurch gekennzeichnet, dass** der Kleber in der Klebstoffschicht ein Polyurethan- und/oder ein Polyester kleber ist.

4. Verwendung eines Kunststoffverbundes nach Anspruch 1, **dadurch gekennzeichnet, dass** der Verbund durch Coextrusion herstellbar ist.

5. Verwendung eines Kunststoffverbundes nach Anspruch 4, **dadurch gekennzeichnet, dass** für die Coextrusion zusätzlich zumindest ein Haftvermittler verwendet wird.

6. Verwendung eines Kunststoff Verbundes nach einem der Ansprüche 1 bis 5, **dadurch gekennzeichnet, dass** zwischen den Schichten eine mit einer aus der Dampfphase abgeschiedenen Oxidschicht versehene Polymerfolie verwendet wird.

7. Verwendung eines Kunststoffverbundes nach Anspruch 6, **dadurch gekennzeichnet, dass** es sich bei der mit einer aus der Dampfphase abgeschiedenen Oxidschicht versehenen Polymerfolie um eine Folie aus Polyethylenterephthalat (PET) oder Polyethylennaphthalat (PEN) oder Ethylentetrafluorethylencopolymer (ETFE) sowie um Coextrudate daraus in Form von Folien oder Folienverbunden handelt.

8. Verwendung eines Kunststoffverbundes nach Anspruch 6 oder 7, **dadurch gekennzeichnet, dass** es sich bei der aus der Dampfphase abgeschiedenen Oxidschicht um eine Aluminiumoxid- oder Siliziumoxidschicht handelt.

9. Verwendung eines Kunststoffverbundes nach Anspruch 1, **dadurch gekennzeichnet, dass** zwischen den Schichten eine Aluminiumfolie verwendet wird.

10. Verwendung eines Kunststoffverbundes nach Anspruch 1, **dadurch gekennzeichnet, dass** auf zumindest einer Schicht eine weitere Schicht als Adhäsionsschicht vorgesehen ist.

11. Verwendung eines Kunststoffverbundes nach Anspruch 10, **dadurch gekennzeichnet, dass** die Adhäsionsschicht ein- oder mehrlagig ist und aus Polyurethan und/oder Polyester und/oder Polyacrylat besteht.

12. Verwendung eines Kunststoffverbundes nach Anspruch 10 oder 11, **dadurch gekennzeichnet, dass** die Adhäsionsschicht mittels Coextrusion aufgebracht wird.

13. Verwendung eines Kunststoffverbundes nach Anspruch 10 oder 11, **dadurch gekennzeichnet, dass** die Adhäsionsschicht mit einem Walzenauftragswerk aufgetragen wird.

14. Verwendung eines Kunststoffverbundes nach einem der Ansprüche 1 bis 13, **dadurch gekennzeichnet, dass** zumindest eine Schicht eingefärbt ist.

15. Verwendung eines Kunststoffverbundes nach Anspruch 1, **dadurch gekennzeichnet, dass** die Schicht (3, 3') mittels physikalischer Medien vorbehandelt wird.

16. Verwendung eines Kunststoffverbundes nach Anspruch 1, **dadurch gekennzeichnet, dass** auf die Schicht (2, 2') oder die Schicht (4, 4') eine Siegelschicht (5, 5') aufgebracht wird.

17. Verwendung eines Kunststoffverbundes nach Anspruch 16, **dadurch gekennzeichnet, dass** es sich bei der Siegelschicht (5, 5') um Ethylen vinylacetat (EVA) oder Polyvinylbutyral (PVB) oder lonomere oder Polymethylmethacrylat (PMMA) oder Polyurethan oder Polyester oder Hotmelt, sowie Coextrudate daraus in Form von Folien oder Folienverbunden handelt.

18. Verwendung eines Kunststoffverbundes nach Anspruch 1, **dadurch gekennzeichnet, dass** die Schicht (2, 2') oder (4, 4') physikalisch und/oder chemisch an zumindest einer Oberseitenfläche behandelt wird.

## Claims

1. Use of a plastic composite (1, 1') comprising a carrier material (3, 3') selected from the group of polyethylene terephthalate (PET), polyethylene naphthalate (PEN) or ethylene tetrafluoroethylene copolymer (ETFE), as well as polyamide 12 layers (2, 2', 4, 4') adjoining the carrier material on both sides for the production of photovoltaic modules (24).

2. The use of a plastic composite according to claim 1, **characterised in that** the carrier material (3, 3') is non-positively joined to the polyamide 12 layers (2, 2', 4, 4') by means of an adhesive layer.

3. The use of a plastic composite according to claim 2, **characterised in that** the adhesive in the adhesive layer is a polyurethane and/or a polyester adhesive.

4. The use of a plastic composite according to claim 1, **characterised in that** the composite can be produced by co-extrusion.

5. The use of a plastic composite according to claim 4, **characterised in that** at least one adhesion promoter is additionally used for the coextrusion.

6. The use of a plastic composite according to any one of claims 1 to 5, **characterised in that** a polymer film provided with an oxide layer deposited from the vapour phase is used between the layers.

7. The use of a plastic composite according to claim 6, **characterised in that** the polymer film provided with an oxide layer deposited from the vapour phase comprises a film of polyethylene terephthalate (PET) or polyethylene naphthalate (PEN) or ethylene tetrafluoroethylene copolymer (ETFE) as well as a co-extrudate therefrom in the form of films or film composites.

8. The use of a plastic composite according to claim 6 or 7, **characterised in that** the oxide layer deposited from the vapour phase comprises an aluminium oxide or silicon oxide layer.

9. The use of a plastic composite according to claim 1, **characterised in that** an aluminium film is used between the layers.

10. The use of a plastic composite according to claim 1, **characterised in that** a further layer is provided as an adhesion layer on at least one layer.

11. The use of a plastic composite according to claim 10, **characterised in that** the adhesion layer is single- or multi-layered and consists of polyurethane and/or polyester and/or polyacrylate.

12. The use of a plastic composite according to claim 10 or 11, **characterised in that** the adhesion layer is applied by means of co-extrusion.

13. The use of a plastic composite according to claim 10 or 11, **characterised in that** the adhesion layer is applied by means of a roller application unit.

14. The use of a plastic composite according to any one of claims 1 to 13, **characterised in that** at least one layer is coloured.

15. The use of a plastic composite according to claim 1, **characterised in that** the layer (3, 3') is pretreated by means of physical media.

16. The use of a plastic composite according to claim 1, **characterised in that** a sealing layer (5, 5') is applied to the layer (2, 2') or the layer (4, 4').

17. The use of a plastic composite according to claim 16, **characterised in that** the sealing layer (5, 5') comprises ethylene vinyl acetate (EVA) or polyvinyl butyral (PVB) or lonomers or polymethyl methacrylate (PMMA) or polyurethane or polyester or hotmelt as well as co-extrudates thereof in the form of films or film composites.

18. The use of a plastic composite according to claim 1, **characterised in that** the layer (2, 2') or (4, 4') is treated physically and/or chemically on at least one upper surface.

## Revendications

1. Utilisation d'un composite en matière plastique (1, 1') comprenant un matériau de support (3, 3') choisi dans le groupe constitué par le polyéthylènetéréphtalate (PET), le polyéthylènenaphtalate (PEN) ou l'éthylènetétrafluoroéthylène-copolymère (ETFE) ainsi que des couches en polyamide-12 (2, 2', 4, 4') disposées de façon adjacente sur les deux faces dudit matériau de support, pour fabriquer des modules photovoltaïques (24).

2. Utilisation d'un composite en matière plastique selon la revendication 1, **caractérisée en ce que** le matériau de support (3, 3') est reliée aux couches en polyamide-12 (2, 2', 4, 4') par l'intermédiaire d'une couche d'un agent adhésif, de façon à obtenir une liaison par adhérence.

3. Utilisation d'un composite en matière plastique selon la revendication 2, **caractérisée en ce que** l'adhésif dans ladite couche d'un agent adhésif est un adhésif de type polyuréthane ou polyester.

4. Utilisation d'un composite en matière plastique selon la revendication 1, **caractérisée en ce que** le composite peut être fabriqué par co-extrusion.

5. Utilisation d'un composite en matière plastique selon la revendication 4, **caractérisée en ce que**, pour ladite co-extrusion, on utilise en outre au moins un agent adhésif.

6. Utilisation d'un composite en matière plastique selon l'une des revendications 1 à 5, **caractérisée en ce que** l'on utilise, entre les couches, une feuille polymère pourvue d'une couche d'oxyde appliquée par dépôt en phase vapeur.

7. Utilisation d'un composite en matière plastique selon la revendication 6, **caractérisée en ce que** ladite feuille polymère pourvue d'une couche d'oxyde appliquée par dépôt en phase vapeur est une feuille en polyéthylènetéréphtalate (PET) ou polyéthylènenaphtalate (PEN) ou éthylènetétrafluoroéthylène-copolymère (ETFE) ou bien un co-exdrudat réalisé à partir de cette dernière, en forme de feuilles ou de feuilles composites.

8. Utilisation d'un composite en matière plastique selon les revendications 6 ou 7, **caractérisée en ce que** ladite couche d'oxyde appliquée par dépôt en phase vapeur est une couche d'oxyde d'aluminium ou d'oxyde de silicium.

9. Utilisation d'un composite en matière plastique selon la revendication 1, **caractérisée en ce que** l'on utilise, entre les couches, une feuille en aluminium.

10. Utilisation d'un composite en matière plastique selon la revendication 1, **caractérisée en ce que** l'on prévoit, au moins sur l'une des couches, une couche supplémentaire destinée à servir de couche d'adhésion.

11. Utilisation d'un composite en matière plastique selon la revendication 10, **caractérisée en ce que** ladite couche d'adhésion est composée d'une ou de plusieurs couches et qu'elle est constituée de polyuréthane et/ou de polyester et/ou de polyacrylate.

12. Utilisation d'un composite en matière plastique selon les revendications 10 ou 11, **caractérisée en ce que** ladite couche d'adhésion est appliquée par co-extrusion.

13. Utilisation d'un composite en matière plastique selon les revendications 10 ou 11, **caractérisée en ce que** ladite couche d'adhésion est appliquée par un dispositif d'application à rouleaux.

14. Utilisation d'un composite en matière plastique selon l'une des revendications 1 à 13, **caractérisée en ce qu'**au moins une des couches est colorée.

15. Utilisation d'un composite en matière plastique selon la revendication 1, **caractérisée en ce que** la couche (3, 3') subit un prétraitement au moyen de médias physiques.

16. Utilisation d'un composite en matière plastique selon la revendication 1, **caractérisée en ce que** l'on applique, sur la couche (2, 2') ou la couche (4, 4'), une couche de scellement (5, 5').

17. Utilisation d'un composite en matière plastique selon la revendication 16, **caractérisée en ce que** la couche de scellement (5, 5') est constituée d'éthylène-acétate de vinyle (EVA) ou de polyvinyle de butyral (PVB) ou de ionomères ou de polyméthylméthacrylate (PMMA) ou de polyuréthane ou de polyester ou de colle thermofusible, ou bien de leurs co-extrudats en forme de feuilles ou de feuilles composites.

18. Utilisation d'un composite en matière plastique selon la revendication 1, **caractérisée en ce que** les couches (2, 2') ou (4, 4') subissent, au moins sur l'une de leurs faces supérieures, un traitement physique et/ou chimique.
